# EUROPEAN PATENT SPECIFICATION

(11) **EP 4 561 284 B1**
(45) Date of publication and mention of the grant of the patent: **11.11.2026**
(21) Application number: 25170647.9
(22) Date of filing: 13.12.2018
(51) Int. Cl.: G06F 1/20, H05K 7/20

(54) **COMPUTING DEVICES WITH INTEGRATED AND ISOLATED LIQUID COOLING**
RECHNERVORRICHTUNGEN MIT INTEGRIERTER UND ISOLIERTER FLÜSSIGKEITSKÜHLUNG
DISPOSITIFS INFORMATIQUES À REFROIDISSEMENT PAR LIQUIDE INTÉGRÉ ET ISOLÉ

(43) Date of publication of application: 28.05.2025
(60) Divisional application: 25205197.4 / 4 648 573
(62) Document number(s) of the earlier application(s) in accordance with Art. 76 EPC: 18942730.5 / 3 894 986
(73) Proprietor: Hewlett-Packard Development Company, L.P., Spring, TX 77389 (US)
(72) Inventor: Pennington Jr., John William, Palo Alto, California 94304 (US); Patil, Rahul Shrikant, Taipei, Taipei City 11568 (TW)
(74) Representative: Plasseraud IP

(56) References cited:
- WO-A1-2018/222618
- US-A1- 2007 047 203
- US-A1- 2011 058 330
- US-A1- 2017 347 498
- US-A1- 2018 299 931

## Description

### BACKGROUND

Personal computers for gaming, and other types of heavy duty processing applications, include powerful processors and graphics boards that can get very hot during heavy usage. As such, liquid cooling has been used to cool components that get hot, but such liquid cooling systems can be challenging to integrate without degrading cooling performance.

US 2017/0347498 A1 discloses a multi-compartment computing device with shared cooling device.

### SUMMARY

According to the present invention, there is provided a computing device according to Claim 1. Optional and/or preferred features are defined in the dependent claims.

### BRIEF DESCRIPTION OF THE DRAWINGS

Reference will now be made, by way of example only, to the accompanying drawings in which:
FIG. 1 is a side external view of an example computing device with integrated and isolated liquid cooling, with internal components depicted in outline;
FIG. 2 is a side view of the example computing device of FIG. 1 with a side removed to show the internal components;
FIG. 3 is a perspective top view of the example computing device of FIG. 1 showing an airgap-facing side of a first compartment that contains processing components, and an opposing side of a second compartment that contains cooling components, the opposing side opposing a respective airgap-facing side of the second compartment;
FIG. 4 is a perspective bottom view of the example computing device of FIG. 1 showing the airgap-facing side of the second compartment that contains cooling components;
FIG. 5 is a perspective bottom view of another example computing device with integrated and isolated liquid cooling;
FIG. 6 is a side view of another example computing device with integrated and isolated liquid cooling, with a side removed to show internal components; and
FIG. 7 depicts a top perspective view of the example computing device of FIG. 6, with a side removed and the internal components removed to show an angled plate that forms an aperture-facing side of a second compartment which includes openings.

### DETAILED DESCRIPTION

Personal computers for gaming, and other types of heavy duty processing applications, include powerful processors, and/or graphics boards that can get very hot during heavy usage. As such, liquid cooling has been used to cool components that get hot, but such liquid cooling systems can be challenging to integrate. For example, a liquid cooling system may be inside a housing of a computing device, in a same compartment as the internal components of the computing device that are being cooled, and/or other heat generating components; such a location may cause pre-heating of air used by cooling components (such as heat exchangers) of the liquid cooling system which may reduce cooling to the internal components of the computing device, and/or reduce liquid cooling efficiency of the liquid cooling system. While the cooling components of the liquid cooling system may be located outside the housing of the computing device, such an approach requires that tubing of the cooling system be routed outside the housing to the cooling components.

Hence, provided herein is a computing device with integrated and isolated liquid cooling. The computing device comprises a housing that includes a first compartment that contains processing components, and a second compartment that contains cooling components of a liquid cooling system. The two compartments are separated by an airgap, and/or an aperture in the housing, that physically separates and thermally isolates the first compartment and the second compartment, the airgap, and/or the aperture, defined by external surfaces of the housing. The two compartments are joined, at one side, or opposing sides, of the airgap and/or aperture by a conduit and/or conduits that provide an internal path within the housing for tubes and electrical wires of the liquid cooling system that convey liquid carrying heat from the processing components in the first compartment to the cooling components in the second compartment. Hence, the liquid cooling system, and/or the cooling components of the liquid cooling system, are integrated into the computing device, but isolated from the processing components that emit heat.

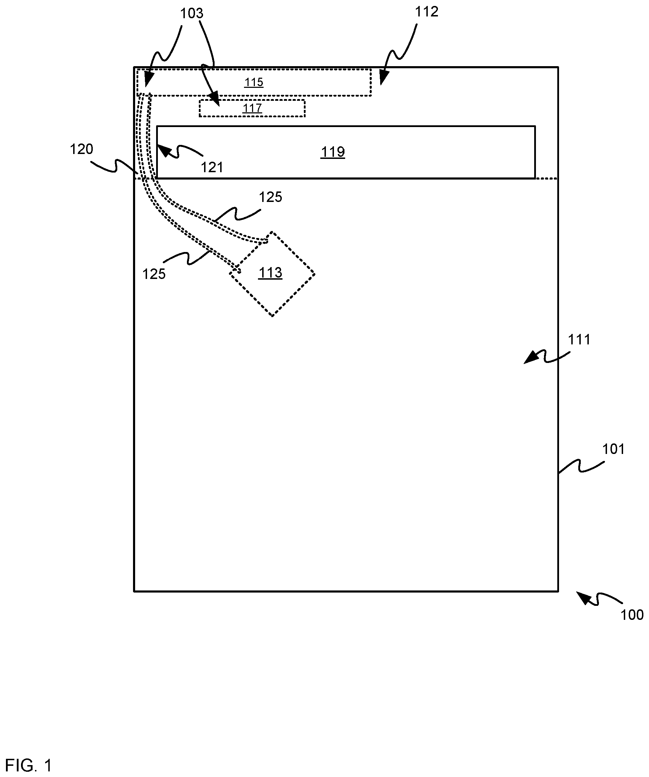

Referring to FIG. 1, a side external view of an example computing device 100 with integrated and isolated liquid cooling is depicted, with internal components depicted in outline. The computing device 100 is interchangeably referred to hereafter as the device 100. The device 100 comprises a housing 101 and a liquid cooling system 103. The device 100 further comprises a first compartment 111 of the housing 101 and a second compartment 112 of the housing 101. The first compartment 111 of the housing 101 contains processing components 113. The second compartment 112 of the housing 101 contains cooling components 115, 117 of the liquid cooling system 103 described in more detail below.

The device 100 further comprises an airgap 119 in the housing 101 that physically separates and thermally isolates the first compartment 111 and the second compartment 112, the airgap 119 defined by external surfaces of the housing 101.

The device 100 further comprises a conduit 120 of the housing 101 that joins the first compartment 111 and the second compartment 112 at a side 121 of the airgap 119. The side 121 further corresponds to an airgap-facing side of the conduit 120.

The conduit 120 routes, internal to the housing 101, tubing 125 of the liquid cooling system 103 from the first compartment 111 to the second compartment 112, the tubing 125 conveying liquid that carries heat from the processing components 113 to the cooling components 115, 117 for dissipation.

Hence, for example, the cooling components 115, 117, such as a heat exchanger and/or a fan, are physically and thermally isolated from the processing components 113, as the cooling components 115, 117are located in the second compartment 112, and the processing components 113 are located in the first compartment 111 and separated by the airgap 119. The tubing 125 is routed through the conduit 120 which further restricts air flow, and/or heat flow, between the first compartment 111 and the second compartment 112. Hence, the first compartment 111 and the second compartment 112 are further physically and thermally isolated from each other via the conduit 120 while the conduit 120 further physically connects the first compartment 111 and the second compartment 112 (e.g., at a distance from each other), while providing a path for the tubing 125 and/or the liquid contained therein and/or the heat.

The processing components 113 may include a central processing unit (CPU) and/or a graphics processing unit and/or a graphics card, and the like.

While the liquid cooling system 103 is described as including the cooling components 115, 117 and the tubing 125, the liquid cooling system 103 may comprise any other suitable components including, but not limited to, a pump, an external connection to a liquid source, and the like. For example, the liquid may be water and the device 100 may include an external connection to a water tap, and the like. However, the liquid cooling system 103 may be a closed-loop liquid cooling system in which heated liquid is conveyed from the processing components 113 to the cooling components 115, 117 by a first tube of the tubing 125 and cooled liquid is conveyed from the cooling components 115, 117 back to the processing components 113 by a second tube of the tubing 125 (e.g., as depicted).

Furthermore, the processing components 113 may be adapted for use with the liquid cooling system 103, and hence may include a reservoir or reservoirs, and the like, to receive the liquid of the tubing 125, the reservoir or reservoirs for promoting heat exchange between the processing components 113 and the liquid.

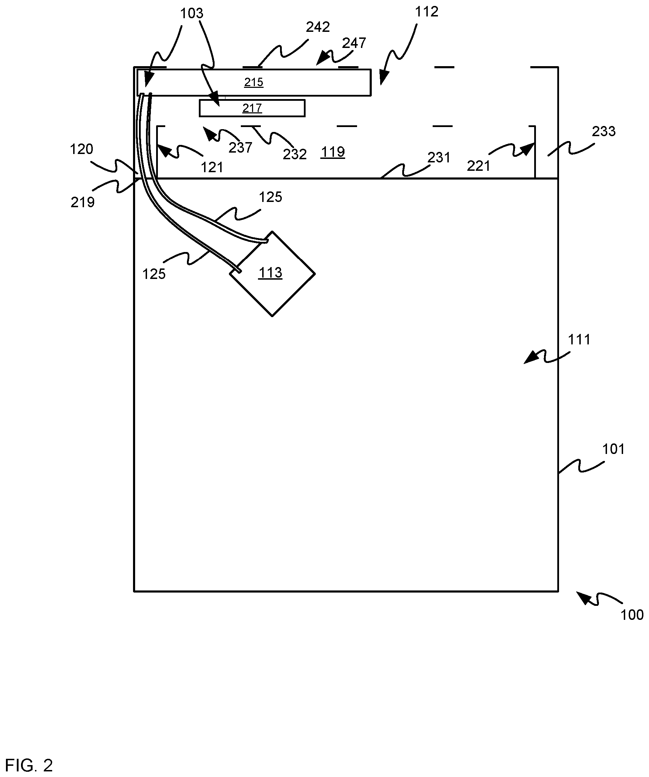

Referring next to FIG. 2, a side view of the example device 100 is depicted with a side of the housing 101 removed to show the internal components including the interior of the first compartment 111, which contains the processing components 113, and the interior of the second compartment 112 which contains the cooling components 115, 117. For example as depicted the cooling components 115, 117 include a heat exchanger 215 and a fan 217 (which respectively correspond to the cooling components 115, 117 of FIG. 1). While only one heat exchanger 215 and one fan 217 are depicted, the cooling components 115, 117 may include more than one heat exchanger 215, and/or more than one fan 217.

FIG. 2 further shows the tubing 125 routed from the processing component 113 into the conduit 120 at a side 121 of the airgap 119 to the heat exchanger 215. In particular, as depicted, the device 100 may include material 219 in the conduits 120 that restricts airflow between the first compartment 111 and the second compartment 112. For example, as depicted, the material 219 comprises a panel which include holes, and the like, through which the tubing 125 passes. However, the material 219 may include thermally insulating material, and the like.

While, as depicted, the panel of the material 219 separates the conduit 120 from the first compartment 111, and the conduit 120 is open to the second compartment 112, in other examples, the conduit 120 may include a panel that separates the conduit 120 from the second compartment 112 (with holes and the like for the tubing 125).

While not depicted, the conduit 120 may further route, internal to the housing 101, a power cable and/or power cables to the fan 217 from a power supply (not depicted) contained in the first compartment 111 (e.g., with the material 219 adapted to include a hole and/or holes for a power cable for the fan 217).

The side 121 of the airgap 119 ( as well as an opposing side 221) generally join respective airgap-facing sides 231, 232 of the first compartment 111 and the second compartment 112. In general, the airgap-facing sides 231, 232 of the first compartment 111 and the second compartment 112 oppose one another across the airgap 119. As depicted, the airgap-facing sides 231, 232 of the first compartment 111 and the second compartment 112 are about parallel to one another; however the airgap-facing sides 231, 232 of the first compartment 111 and the second compartment 112 may be at any suitable angle and/or angles to each other to increase an area for air entry into the second compartment 112.

Furthermore, while as depicted the second compartment 112 includes a hollow region 233 that extends to the first compartment 111 (e.g., which may be used as an alternative conduit therebetween), the hollow region 233, and the first compartment 111, are separated by a panel that does not include openings

(e.g., which may be adapted to include openings for tubing 125 when the hollow region 233 is used as an alternative conduit). The hollow region 233 may also be filled, and/or partially filled, with thermally insulating material to assist with preventing heat from flowing between the compartments 111, 112.

In particular, as described above, the cooling components 115, 117 of the second compartment 112 include a fan 217, positioned at the airgap-facing side 232 of the second compartment 112 to draw unheated external air from the airgap 119 into the second compartment 112 to assist with dissipating the heat conveyed to cooling components by the tubing 125. For example, as depicted, the airgap-facing side 232 of the second compartment 112 includes openings 237 and/or vents to draw air into the second compartment 112, for example via the fan 217. While the openings 237 are depicted in particular positions in FIG. 2, the openings 237 may be in any suitable location in the airgap-facing side 232.

Furthermore, as described above, the cooling components 115, 117 of the second compartment 112 include a heat exchanger 215 connected to the tubing 125. with the fan 217 positioned at the airgap-facing side 232 of the second compartment 112 to draw air from the airgap 119 across the heat exchanger 215 (e.g., through the openings 237). Furthermore, an opposing side 242 of the second compartment 112, opposing the airgap-facing side 232, include openings 247 or vents through which the air exits the second compartment 112. While the openings 247 are depicted in particular positions in FIG. 2, the openings 247 may be in any suitable location in the airgap-facing side 232.

Hence, for example air is drawn into the second compartment 112 from the airgap 119 through the openings 237 via the fan 217; the air flows across the heat exchanger 215. Liquid from a first tube of the tubing 125 generally flows into the heat exchanger 215 carrying the heat from the processing components 113, and the air that flows across the heat exchanger 215 dissipates the heat from the liquid in the heat exchanger 215 through the openings 247. As such, the heat exchanger 215 may include heat fins, and the like, positioned to radiate heat through the openings 247.The liquid then flows out of the heat exchanger 215 through a second tube of the tubing 125 back to the processing components 113 to again carry heat to the heat exchanger 215.

While the heat exchanger 215 is described with respect to heat fins, and the like, the heat exchanger 215 may have any suitable configuration, and/or be any suitable type of the heat exchanger.

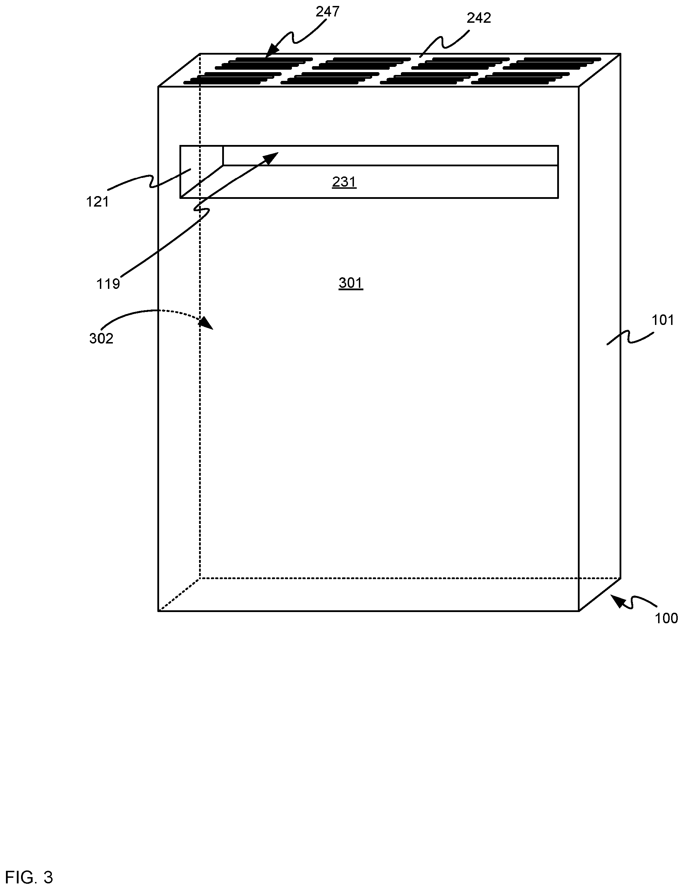

Attention is next directed to FIG. 3 which depicts a perspective top view of the example device 100 of FIG. 1.

FIG. 3 showing the airgap-facing side 231 of the first compartment 111 and the opposing side 242 of the second compartment 112. In the view of FIG. 3, the airgap 119 is shown as being through the housing 101. For example, the airgap 119 extends from a first external surface 301 of the housing 101 through to a second external surface 302 of the housing 101, the external surfaces 301, 302 opposing one another. The external surface 302 is depicted in outline to indicate that the external surface 302 is located behind the external surface 301, and/or is otherwise hidden in FIG. 3. The external surfaces 301, 302 are joined by side and bottom external surfaces of the housing 101, as well as by sides 121, 221 of the airgap 119, and the airgap-facing sides 231, 232 of the compartments 111, 112 (which also correspond to surfaces of the airgap 119 which join the sides 121, 221).

Furthermore, the opposing external surfaces 301, 302 of the housing 101 each include respective external surfaces of the first compartment 111, the second compartment 112 and the conduit 120, such that, for example, the surfaces of the housing 101 which coincide with the first compartment 111, the second compartment 112 and the conduit 120 form respective surfaces of the first compartment 111, the second compartment 112 and the conduit 120. However, the housing 101 and/or the first compartment 111 and/or the second compartment 112 and/or the conduit 120 may be fabricated from any suitable number of panels, and the like using, for example, sheet metal.

As is further depicted in FIG. 3, the airgap-facing side 231 of the first compartment 111 is closed to prevent heat from the first compartment 111 from flowing into the airgap 119, for example via convection.

As is further depicted in FIG. 3, the opposing side 242 of the second compartment 112 includes the openings 247, for example in a venting pattern, for heat from the heat exchanger 215 to vent therethrough.

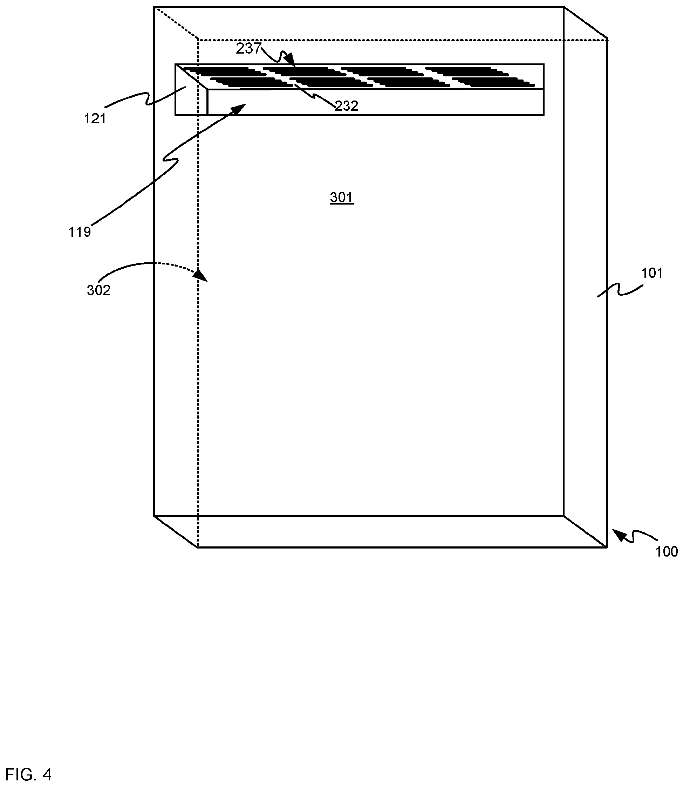

Attention is next directed to FIG. 4 which depicts a perspective bottom view of the example device of FIG. 1 showing the airgap-facing side 232 of the second compartment 112, as well as the external surface 301 of the housing 101, and the side 121 of the airgap 119. As in FIG. 3, airgap 119 is shown as being through the housing 101 and extending between the external surfaces 301, 302, with the external surface 302 understood to be hidden in FIG. 4.

FIG. 4 further shows the openings 237 in the airgap-facing side 232 of the second compartment 112 through which air from the airgap 119 flows into the second compartment 112, the openings 237 arranged in a venting pattern.

FIG. 4 further shows that the airgap-facing side 232 of the second compartment 112 extends from the first external surface 301 to the second external surface 302.

Hence, as depicted in FIG. 3 and FIG. 4, the airgap 119 is through the housing 101 from the first external surface 301 of the housing 101 to the second external surface 302 of the housing 101, the airgap 119 defined by opposing airgap-facing sides 231, 232 of the first compartment 111 and the second compartment 112, and an airgap-facing side of the conduit 120 (e.g., which coincides with the side 121 of the airgap 119).

Hence, from FIG. 3 and FIG. 4, the airgap 119 is understood to comprise an aperture through the housing 101 and/or a hole through the housing 101, and the like. However, the airgap 119 may have other configurations.

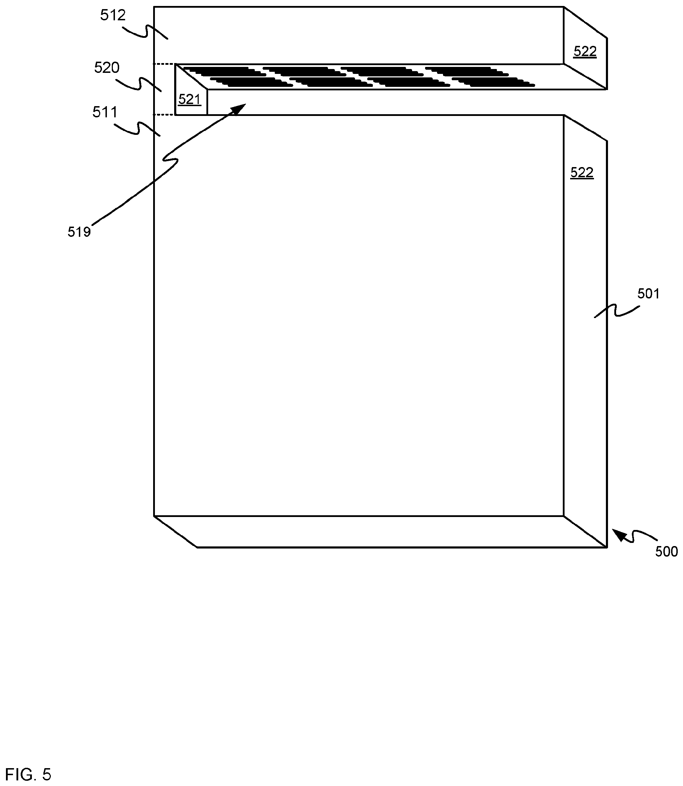

For example, attention is next directed to FIG. 5 which depicts a perspective bottom view of an example computing device 500 similar to the device 100. Hence, like the device 100, the computing device 500 includes a housing 501, a first compartment 511, that contains processing components (not depicted), and a second compartment 512, that contains cooling components not depicted) of a liquid cooling system. While internal components of the computing device 500 are not depicted, internal components corresponding to the internal components of the device 100 are nonetheless understood to be present.

The computing device 500 further includes an airgap 519 in the housing 501 that physically separates and thermally isolates the first compartment 511 and the second compartment 512, the airgap 519 defined by external surfaces of the housing 501. The computing device 500 further includes a conduit 520 of the housing 501 that joins the first compartment 511 and the second compartment at a side 521 of the airgap 519. The conduit 520 generally routes tubing between the compartments 511, 512. In FIG. 5, the internal positions of the first compartment 511, the second compartment 512 and the conduit 520 are depicted in outline.

However, in contrast to the airgap 119, which comprises an aperture and/or hole, the airgap 519 comprises a bight in the housing and/or an absence of material in the housing 501 and/or a slot in the housing 501 that extends from the conduit 520 through to an opposite side 522 of the housing 501. For example, as depicted, the second compartment 512 forms a shelf that is cantilevered and/or hanging, and the like, relative to the airgap 519 and supported by the conduit 520.

In yet further examples, computing devices with integrated and isolated liquid cooling according to the present specification may have other configurations, and/or be adapted for a plurality of processing components.

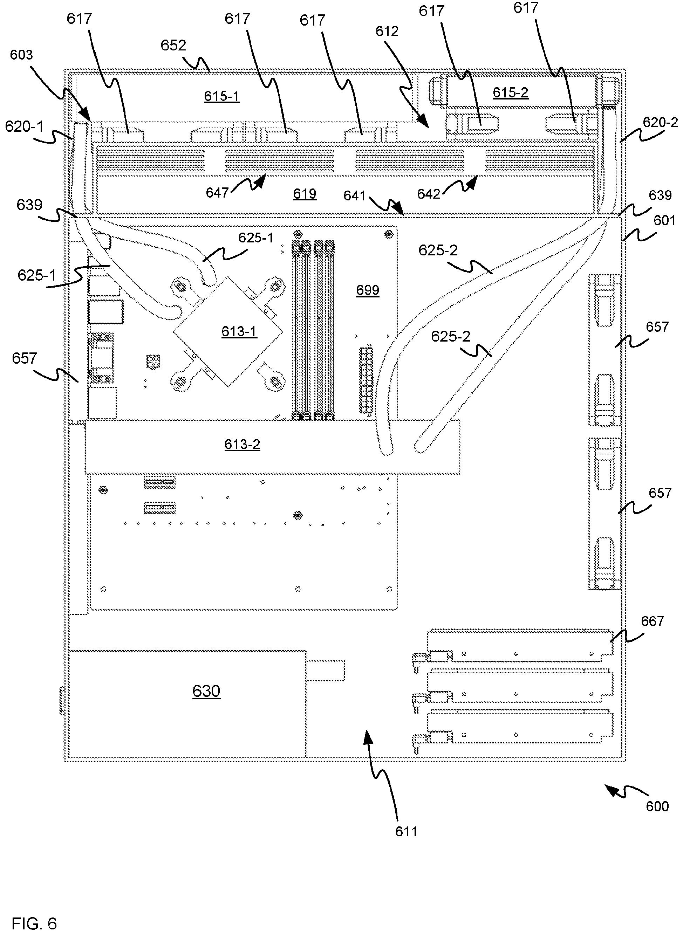

For example, attention is next directed to FIG. 6 which depicts an example computing device 600 with integrated and isolated liquid cooling. The computing device 600 (interchangeably referred to hereafter as the device 600), which is similar to the device 100, with like components having like numbers, however in a "600" series rather than a "100" series. However, as will be described below, in contrast to the device 100, the device 600 includes two conduits, two processing components, and two heat exchangers, for example one heat exchanger for each the two processing components. In particular, the device 600 is depicted with a side removed to show internal components thereof, similar to the view of the device 100 in FIG. 2.

As depicted, the device 600 comprises a housing 601 and a liquid cooling system 603. The device 600 further comprises a first compartment 611 of the housing 601 that contains processing components 613-1, 613-2. For example the processing component 613-1 may comprise a central processing unit (CPU) and the processing component 613-2 may comprise a graphics processing unit (GPU) and/or a graphics board. The processing components 613-1, 613-2 are interchangeably referred to hereafter, collectively, as the processing components 613 and, generically, as a processing component 613

The device 600 further comprises a second compartment 612 of the housing 601 that contains cooling components of the liquid cooling system, the cooling components including a heat exchanger and/or heat exchangers 615-1, 615-2 and a fan 617 and/or fans 617. The heat exchangers 615-1, 615-2 are interchangeably referred to hereafter, collectively, as heat exchangers 615 and, generically, as a heat exchanger 615.

The device 600 further comprises an aperture 619 through the housing 601 that separates the first compartment 611 from the second compartment 612. The aperture 619 is similar to the airgap 119 of the device 100.

The device 600 further comprises two conduits 620-1, 620-2 of the housing 601 that join the first compartment 611 and the second compartment 612 on opposite sides of the aperture 619, the two conduits 620-1, 620-2 routing, internal to the housing 601, tubing 625-1, 625-2 of the liquid cooling system 603 from the first compartment 611 to the second compartment 612, the tubing 625-1, 625-2 conveying liquid that carries heat from the processing components 613 to the cooling components for dissipation, and in particular the heat exchangers 615.

The conduits 620-1, 620-2 are interchangeably referred to hereafter, collectively, as the conduits 620 and, generically, as a conduit 620.The tubing 625-1, 625-2 is interchangeably referred to hereafter, collectively, as tubing 625 and, generically, as the tubing 625.

While not depicted, one conduit 620 or both conduits 620 further route, internal to the housing 601, a power cable and/or power cables to the fan and/or fans 617 from a power supply 630 contained in the first compartment 611.

As with the device 100, the two conduits 620 restrict airflow between the first compartment 611 and the second compartment 612 and may include material in the two conduits 620 that restrict airflow between the first compartment 611 and the second compartment 612. The material may include, as depicted, respective panels 639 between the two conduits 620 and the first compartment 611 with holes and/or apertures for the tubing 625. The material may further include thermally insulating material.

While as depicted, the conduits 620 are joined with and/or open to the second compartment 612, in other examples the conduits 620 may include respective panels therebetween, similar to the panels 639, with holes for the tubing 625 (and/or power cables).

While in FIG. 6 the device 600 is depicted with a side removed to show in internal components, it is understood that, like the device 100, the device 600 includes opposing external surfaces of the housing 601 (e.g., similar to the external surfaces 301, 302) which include respective external surfaces of the first compartment 611, the second compartment 612 and the two conduits 620.

As further depicted in FIG. 6, the first compartment 611 and the second compartment 612 each include respective aperture-facing sides 641, 642, described in more detail below.

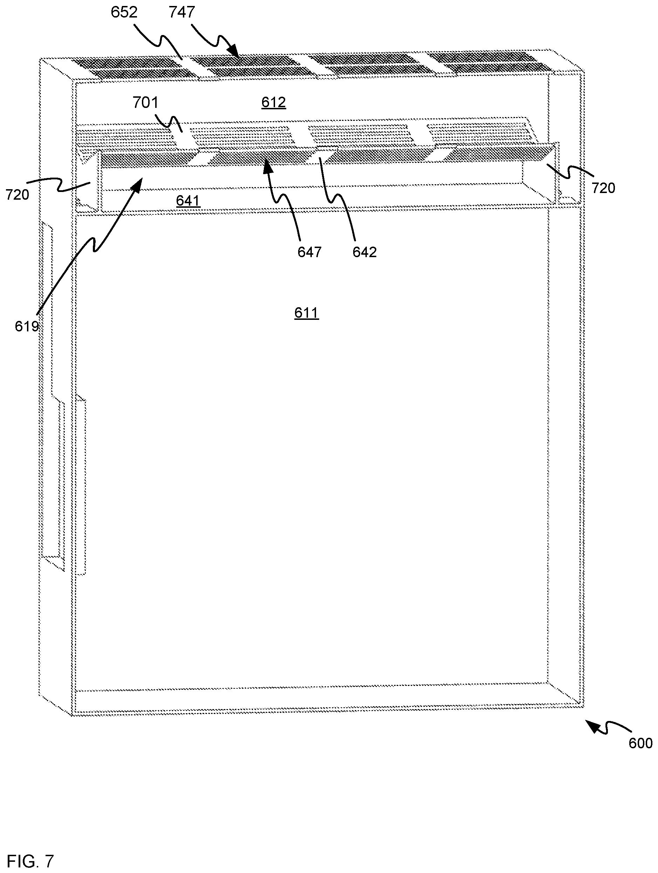

Furthermore, a fan and/or fans 617 of the second compartment 612 are at the aperture-facing side 642 of the second compartment 612 to draw in air from the aperture 619 (for example through openings 647 at the aperture-facing side 642) and across the heat exchanger and/or heat exchangers 615. Furthermore, as will be shown in FIG. 7 described below, an opposing side 652 of the second compartment 612, opposing the aperture-facing side 642, included openings through which the air exits the second compartment 612 after flowing across the heat exchanger and/or heat exchangers 615.

As depicted in FIG. 6, the cooling components in the second compartment 612 include a first heat exchanger 615-1 to which first tubing 625-1 from first processing components 613-1 are routed, by the conduit 620-1, to cool the first processing components 613-1.

However, as also depicted in FIG. 6, the cooling components in the second compartment 612 further include a second heat exchanger 615-2 to which second tubing 625-2 from second processing components 613-2 are routed, by the conduit 620-2, to cool the second processing components 613-2. Hence, the liquid cooling system 603 includes second tubing 625-2 that runs through the conduit 620-2, internal to the housing 601, from the first compartment 611 to the second compartment 612.

In general, the first tubing 625-1 conveys the heat from the first processing components 613-1 (e.g., such as CPU) to the heat exchanger 615-1, and the second tubing 625-2 conveys the heat from the second processing components 613-2 (e.g., such as GPU and/or graphics card) to the second heat exchanger 615-2.

Indeed, the device 600 may comprise a respective heat exchanger 615 for each of the processing components 613-1, 613-2.

For example, as depicted, the processing components 613 include the first processing components 613-1 and the second processing components 613-2, and the heat exchangers 615 comprising respective heat exchangers 615-1, 615-2 for the first processing components 613-1 and the second processing components 613-2, the tubing 625 carrying respective heat from the first processing components 613-1 and the second processing components 613-2 to the respective heat exchangers 615-1, 615-2.

Indeed, in other examples, the processing components 613 include a plurality of processing components 613 (e.g., more than one processing components 613 and/or more than two processing components 613), the heat exchangers 615 comprising plurality of heat exchangers in a one-to-one relationship with the plurality of processing components 613, the tubing 625 carrying respective heat from the plurality of processing components 613 to respective heat exchangers 615 of the plurality of heat exchangers 615.

Hence, for example, while the device 600 is depicted with only CPU (e.g., processing components 613-1) and one GPU and/or graphics card (e.g., processing components 613-2), the device 600 may comprise more than one CPU and/or more than one GPU and/or graphics card with a respective heat exchanger 615 in the second compartment 612 provided for each, and respective tubing 625 provided for each. However, in other examples, due to space limitations, the device 600 may include a fewer number of heat exchangers 615 than processing components 613.

As depicted, the device 600 may include other types of components including, but not limited to, fans 657 through a wall and/or walls of the first compartment 611, hard drives 667, connectors, computer boards, and/or any other suitable component that may be used with a personal computer and/or a computing device and the like. The fans 657 may be used to provide cooling for components in the first compartment 611 that aren't cooled by the liquid cooling system 603; for example fans 657 at a first wall may draw air into the device 600 while other fans 657 at a second wall opposite the first wall may draw air out of the device 600.

Indeed, as depicted, the first processing components 613-1 are mounted to a computer board 699 and the first tubing 625-1 is routed through respective apertures in the board to route liquid in the first tubing 625-1 to the first processing components 613-1, for example to a reservoir of the first processing components 613-1 on a side of the computer board 699 opposite that depicted in FIG. 6. The second processing components 613-2 may be similarly adapted for the liquid cooling system 603.

As depicted, the aperture-facing side 642 of the second compartment 612 includes openings 647 and/or vents similar to the openings 237 in the airgap-facing side 232 of the device 600. However, while airgap-facing sides 231, 232 of the first compartment 111 and the second compartment 112 are about parallel to one another, as best seen in FIG. 7, the aperture-facing side 642 of the second compartment 612 is in a "V" shape, with a center of the "V" extending into the aperture 619 centered along a longitudinal axis of the aperture 619, such that the openings 647 are angled with respect to the fans 617 and/or the aperture 619 and/or the aperture-facing side 641 of the first compartment 611.

For example, FIG. 7 depicts a top perspective view of the device 600 with a side removed and the internal components removed to show an angled ("V"-shaped) plate 701 that forms two portions of the aperture-facing side 642 of the second compartment 612 including the openings 647, each of the portions of the aperture-facing side 642 angled in generally opposite directions out of the opening 619. Opposing sides 720 of the aperture 619 that are perpendicular to the aperture-facing side 641 of the first compartment 611 may each include a notch (e.g., a complementary "V"-shaped notch) into which the angled plate 701 is placed and/or attached. Furthermore, the angle of the angled plate 701, and/or the angle of the portions of the aperture-facing side 642, may be selected to promote flow of air into the second compartment 612 by the fans 617 from the aperture 619 and/or a region adjacent to the aperture 619.

In particular, by angling the portions aperture facing side 642 (e.g., in two directions), and hence angling the openings 647, the second compartment 612 has an increased area for air entry, for example as compared to the device 100; as such, the number of openings 647, and/or the area of the openings 647, may be increased as compared to the device 100. Any suitable angle is within the scope of the present specification; as depicted, the angle of each portion of the aperture facing side 642 side is about 15 degrees with respect to the aperture facing side 641, however the angle can be as large as 45 degrees, though the larger the angle, the smaller the opening 619. Hence, selection of the angle may be tradeoff between area of the aperture facing side 642 and the size of the opening 619.

While the plate 701 and the two portions of the aperture-facing side 642 are depicted as a "V"-shape (e.g., along a longitudinal axis of the opening 619 and/or the plate 701 and/or the second compartment 612), the aperture-facing side 642 may be any suitable shape which causes an increased area for air entry into the second compartment 612 (e.g., as compared to the device 100). For example, the aperture-facing side 642 may be curved, and the like.

Furthermore, while present examples are described with respect to the airgap 119 and/or the aperture 619 being rectangular in shape, the airgap 119 and/or the aperture 619 may be in any suitable shape.

FIG. 7 further shows openings 747 and/or vents in the opposing side 652 of the second compartment 612, through which air is vented from the second compartment 612.

## Claims

1. A computing device comprising:
a housing (101; 601);
a liquid cooling system (103; 603);
a first compartment (111; 611) of the housing (101; 601) that contains processing components (113; 613);
a second compartment (112; 612) of the housing (101; 601) that contains cooling components (115, 117; 215, 217; 617) of the liquid cooling system (103; 603);
an aperture (119; 619) through the housing that separates the first compartment (111; 611) from the second compartment (112; 612); and,
two conduits (120; 233; 620, 620-n) of the housing that join the first compartment (111; 611) and the second compartment (112; 612) on opposite sides of the aperture (619), the two conduits (120; 233; 620, 620-n) routing, internal to the housing (101; 601), tubing (125; 625, 625-n) of the liquid cooling system from the first compartment (111; 611) to the second compartment (112; 612), the tubing (125; 625, 625-n) conveying liquid that carries heat from the processing components (113; 613) to the cooling components (115, 117; 215, 217; 617) for dissipation.

2. The computing device of claim 1, wherein an aperture-facing side (642) of the second compartment (112; 612) is an angled plate or is curved.

3. The computing device of claim 2, wherein the aperture-facing side (642) of the second compartment (112; 612) is a "V"-shaped angled plate.

4. The computing device of claim 3, wherein the V-shaped angled plate (642) includes two angled portions, and wherein an angle of each angled portion of the "V"-shaped angled plate (642) with respect to an aperture facing side (641) of the first compartment (111; 611) is between 15 degrees and 45 degrees.

5. The computing device of claim 2, 3 or 4, wherein the aperture-facing side (642) of the second compartment (112; 612) includes openings and/or vents.

6. The computing device of any preceding claim, wherein the processing components (113; 613) include a central processing unit, CPU, and/or a graphics processing unit and/or a graphics card.

7. The computing device of any preceding claim, wherein the cooling components (115, 117; 215, 217; 617) include a fan (117; 217; 617), the two conduits (120; 233; 620, 620-n) further routing, internal to the housing (101; 601), a power cable to the fan (117; 217; 617) from a power supply contained in the first compartment (111; 611).

8. The computing device of any preceding claim, wherein the two conduits (120, 233; 620-n) restrict airflow between the first compartment (111; 611) and the second compartment (112; 612).

9. The computing device of any preceding claim, further comprising material (219) in the two conduits (120; 233; 620, 620-n) that restrict airflow between the first compartment (111; 611) and the second compartment (112; 612).

10. The computing device of any preceding claim, wherein opposing external surfaces of the housing (101; 601) each include respective external surfaces of the first compartment (111; 611), the second compartment (112; 612) and the two conduits (120; 233; 620, 620-n).

11. The computing device of any of claims 2 to 6,
wherein the cooling components (115, 117; 215, 217; 617) of the liquid cooling system include a fan (117; 217; 617) and a heat exchanger (115; 215; 615) connected to the tubing (125; 625, 625-n) of the liquid cooling system
wherein the tubing (125; 625, 625-n) conveys the liquid that carries heat from the processing components (113, 613) to the heat exchanger (115; 215; 615) for dissipation, and
wherein the fan (117; 217; 617) is positioned in the second compartment (112; 612) at an aperture-facing side (642) of the second compartment to draw in air from the aperture (119; 619) across the heat exchanger (115; 215; 615), an opposing side (242; 652) of the second compartment (112; 612), opposing the aperture-facing side (232; 642) of the second compartment (112; 612), including openings (247; 647) through which the air exits the second compartment (112; 612) after flowing across the heat exchanger (115; 215; 615).

12. The computing device of claim 11, wherein the cooling components (615, 617) in the second compartment (612) further include a second heat exchanger (615-2), and the liquid cooling system includes second tubing (625-2) that runs through the conduits (620-1, 620-2), internal to the housing (601), from the first compartment (611) to the second compartment (612), the tubing (125; 625, 625-n) conveying the heat from a first processor (613-1) of the processing components to the heat exchanger (615-1), and the second tubing (625-2) conveying the heat from a second processor (613-2) of the processing components to the second heat exchanger (615-2).

13. The computing device of claim 11, wherein the processing components include first processing components (613-1) and second processing components (613-2), the heat exchanger comprising respective heat exchangers (615-1, 615-2) for the first processing components (613-1) and the second processing components (613-2), the tubing (625, 625-n) carrying respective heat from the first processing components (613-1) and the second processing components (613-2) to the respective heat exchangers (615-1; 615-2), or
wherein the processing components include a plurality of processing components (613-1, 613-2), the heat exchanger comprising plurality of heat exchangers (615-1; 615-2) in a one-to-one relationship with the plurality of processing components, the tubing (625, 625-n) carrying respective heat from the plurality of processing components (613-1, 613-2) to respective heat exchangers (615-1; 615-2) of the plurality of heat exchangers.

14. The computing device of claim 11, wherein the processing components (113; 613) include a central processing unit, CPU, and a graphics card, the tubing (125; 625-n) conveying the heat from the CPU and the graphics card to the heat exchanger (115; 215; 615).

## Patentansprüche

1. Rechenvorrichtung, die umfasst:
ein Gehäuse (101; 601);
ein Flüssigkeitskühlsystem (103; 603);
ein erstes Fach (111; 611) des Gehäuses (101; 601), das Verarbeitungskomponenten (113; 613) enthält;
ein zweites Fach (112; 612) des Gehäuses (101; 601), das Kühlkomponenten (115, 117; 215, 217; 617) des Flüssigkeitskühlsystems (103; 603) enthält;
eine Öffnung (119; 619) durch das Gehäuse, die das erste Fach (111; 611) von dem zweiten Fach (112; 612) trennt; und
zwei Leitungen (120; 233; 620, 620-n) des Gehäuses, die das erste Fach (111; 611) und das zweite Fach (112; 612) an gegenüberliegenden Seiten der Öffnung (619) verbinden, wobei die zwei Leitungen (120; 233; 620, 620-n) innerhalb des Gehäuses (101; 601) eine Rohrleitung (125; 625, 625-n) des Flüssigkeitskühlsystems von dem ersten Fach (111; 611) zu dem zweiten Fach (112; 612) führen, wobei die Rohrleitung (125; 625, 625-n) Flüssigkeit, die Wärme von den Verarbeitungskomponenten (113; 613) zu den Kühlkomponenten (115, 117; 215, 217; 617) trägt, für eine Ableitung transportiert.

2. Rechenvorrichtung nach Anspruch 1, wobei eine der Öffnung zugewandte Seite (642) des zweiten Fachs (112; 612) eine abgewinkelte Platte ist oder gekrümmt ist.

3. Rechenvorrichtung nach Anspruch 2, wobei die der Öffnung zugewandte Seite (642) des zweiten Fachs (112; 612) eine "V"-förmige abgewinkelte Platte ist.

4. Rechenvorrichtung nach Anspruch 3, wobei die V-förmige abgewinkelte Platte (642) zwei abgewinkelte Abschnitte einschließt, und wobei ein Winkel jedes abgewinkelten Abschnitts der "V"-förmigen abgewinkelten Platte (642) in Bezug auf eine einer Öffnung zugewandte Seite (641) des ersten Fachs (111; 611) zwischen 15 Grad und 45 Grad beträgt.

5. Rechenvorrichtung nach Anspruch 2, 3 oder 4, wobei die der Öffnung zugewandte Seite (642) des zweiten Fachs (112; 612) Löcher und/oder Belüftungen einschließt.

6. Rechenvorrichtung nach einem der vorstehenden Ansprüche, wobei die Verarbeitungskomponenten (113; 613) eine zentrale Verarbeitungseinheit, CPU, und/oder eine Grafikverarbeitungseinheit und/oder eine Grafikkarte einschließen.

7. Rechenvorrichtung nach einem der vorstehenden Ansprüche, wobei die Kühlkomponenten (115, 117; 215, 217; 617) einen Lüfter (117; 217; 617) einschließen, wobei die zwei Leitungen (120; 233; 620, 620-n) ferner innerhalb des Gehäuses (101; 601) ein Stromkabel von einer in dem ersten Fach (111; 611) enthaltenen Leistungsversorgung zu dem Lüfter (117; 217; 617) führen.

8. Rechenvorrichtung nach einem der vorstehenden Ansprüche, wobei die zwei Leitungen (120, 233; 620-n) einen Luftstrom zwischen dem ersten Fach (111; 611) und dem zweiten Fach (112; 612) einschränken.

9. Rechenvorrichtung nach einem der vorstehenden Ansprüche, das ferner Material (219) in den zwei Leitungen (120; 233; 620, 620-n), die den Luftstrom zwischen dem ersten Fach (111; 611) und dem zweiten Fach (112; 612) einschränken, umfasst.

10. Rechenvorrichtung nach einem der vorstehenden Ansprüche, wobei gegenüberliegende Außenoberflächen des Gehäuses (101; 601) jeweils entsprechende Außenoberflächen des ersten Fachs (111; 611), des zweiten Fachs (112; 612) und der zwei Leitungen (120; 233; 620, 620-n) einschließen.

11. Rechenvorrichtung nach einem der Ansprüche 2 bis 6,
wobei die Kühlkomponenten (115, 117; 215, 217; 617) des Flüssigkeitskühlsystems einen Lüfter (117; 217; 617) und einen Wärmetauscher (115; 215; 615), die mit der Rohrleitung (125; 625, 625-n) des Flüssigkeitskühlsystems verbunden sind, einschließen,
wobei die Rohrleitung (125; 625, 625-n) Flüssigkeit, die Wärme von den Verarbeitungskomponenten (113, 613) zu dem Wärmetauscher (115; 215, 615) trägt, für eine Ableitung transportiert, und
wobei der Lüfter (117; 217; 617) in dem zweiten Fach (112; 612) an einer der Öffnung zugewandten Seite (642) des zweiten Fachs angeordnet ist, um Luft aus der Öffnung (119; 619) über den Wärmetauscher (115; 215; 615) anzusaugen, wobei eine gegenüberliegende Seite (242; 652) des zweiten Fachs (112; 612), die der der Öffnung zugewandten Seite (232; 642) des zweiten Fachs (112; 612) gegenüberliegt, Löcher (247; 647) aufweist, durch die die Luft aus dem zweiten Fach (112; 612) austritt, nachdem sie über den Wärmetauscher (115; 215; 615) geströmt ist.

12. Rechenvorrichtung nach Anspruch 11, wobei die Kühlkomponenten (615, 617) in dem zweiten Fach (612) ferner einen zweiten Wärmetauscher (615-2) einschließen, und das Flüssigkeitskühlsystem eine zweite Rohrleitung (625-2) einschließt, die durch die Leitungen (620-1, 620-2) innerhalb des Gehäuses (601) von dem ersten Fach (611) zu dem zweiten Fach (612) verläuft, wobei die Rohrleitung (125; 625, 625-n) die Wärme, von einem ersten Prozessor (613-1) der Verarbeitungskomponenten zu dem Wärmetauscher (615-1) transportiert, und die zweite Rohrleitung (625-2) die Wärme von einem zweiten Prozessor (613-2) der Verarbeitungskomponenten zu dem zweiten Wärmetauscher (615-2) transportiert.

13. Rechenvorrichtung nach Anspruch 11, wobei die Verarbeitungskomponenten erste Verarbeitungskomponenten (613-1) und zweite Verarbeitungskomponenten (613-2) einschließen, wobei der Wärmetauscher jeweilige Wärmetauscher (615-1, 615-2) für die ersten Verarbeitungskomponenten (613-1) und die zweiten Verarbeitungskomponenten (613-2) umfasst, wobei die Rohrleitung (625, 625-n) jeweilige Wärme von den ersten Verarbeitungskomponenten (613-1) und den zweiten Verarbeitungskomponenten (613-2) zu den jeweiligen Wärmetauschern (615-1; 615-2) trägt, oder
wobei die Verarbeitungskomponenten eine Vielzahl von Verarbeitungskomponenten (613-1, 613-2) einschließen, wobei der Wärmetauscher eine Vielzahl von Wärmetauschern (615-1, 615-2) in einer Einszu-eins-Beziehung mit der Vielzahl von Verarbeitungskomponenten umfasst, wobei die Rohrleitung (625, 625-n) jeweilige Wärme von der Vielzahl von Verarbeitungskomponenten (613-1, 613-2) zu jeweiligen Wärmetauschern (615-1, 615-2) der Vielzahl von Wärmetauschern trägt.

14. Rechenvorrichtung nach Anspruch 11, wobei die Verarbeitungskomponenten (113; 613) einen Hauptprozessor, CPU, und eine Grafikkarte einschließen, wobei die Rohrleitung (125; 625-n) die Wärme von dem CPU und der Grafikkarte zu dem Wärmetauscher (115; 215; 615) transportiert.

## Revendications

1. Dispositif informatique comprenant :
un boîtier (101 ; 601) ;
un système de refroidissement de liquide (103 ; 603) ;
un premier compartiment (111 ; 611) du boîtier (101 ; 601) qui contient des composants de traitement (113 ; 613) ;
un second compartiment (112 ; 612) du boîtier (101 ; 601) qui contient des composants de refroidissement (115, 117 ; 215, 217 ; 617) du système de refroidissement de liquide (103 ; 603) ;
une ouverture (119 ; 619) à travers le boîtier qui sépare le premier compartiment (111 ; 611) du second compartiment (112 ; 612) ; et,
deux conduits (120 ; 233 ; 620, 620-n) du boîtier qui rejoignent le premier compartiment (111 ; 611) et le second compartiment (112 ; 612) sur des côtés opposés de l'ouverture (619), les deux conduits (120 ; 233 ; 620, 620-n) acheminant, à l'intérieur du boîtier (101 ;601), un tube (125 ; 625, 625-n) du système de refroidissement de liquide du premier compartiment (111 ; 611) vers le second compartiment (112 ; 612), le tube (125 ; 625, 625-n) acheminant du liquide qui transporte de la chaleur des composants de traitement (113 ; 613) vers les composants de refroidissement (115, 117 ; 215, 217 ; 617) pour la dissiper.

2. Dispositif informatique selon la revendication 1, dans lequel un côté faisant face à l'ouverture (642) du second compartiment (112 ; 612) est une plaque inclinée ou est incurvé.

3. Dispositif informatique selon la revendication 2, dans lequel le côté faisant face à l'ouverture (642) du second compartiment (112 ; 612) est une plaque inclinée en forme de « V ».

4. Dispositif informatique selon la revendication 3, dans lequel la plaque inclinée en forme de V (642) comporte deux parties inclinées, et dans lequel un angle de chaque partie inclinée de la plaque inclinée en forme de « V » (642) par rapport à un côté faisant face à l'ouverture (641) du premier compartiment (111 ; 611) est compris entre 15 degrés et 45 degrés.

5. Dispositif informatique selon la revendication 2, 3 ou 4, dans lequel le côté faisant face à l'ouverture (642) du second compartiment (112 ; 612) comporte des ouvertures et/ou des évents.

6. Dispositif informatique selon l'une quelconque revendication précédente, dans lequel les composants de traitement (113 ; 613) comportent une unité centrale de traitement, UCT, et/ou une unité de traitement graphique et/ou une carte graphique.

7. Dispositif informatique selon l'une quelconque revendication précédente, dans lequel les composants de refroidissement (115, 117 ; 215, 217 ; 617) comportent un ventilateur (117 ; 217 ; 617), les deux conduits (120 ; 233 ; 620, 620-n) acheminant en outre, à l'intérieur du boîtier (101 ; 601), un câble d'alimentation vers le ventilateur (117 ; 217 ; 617) depuis une alimentation électrique contenue dans le premier compartiment (111 ; 611).

8. Dispositif informatique selon l'une quelconque revendication précédente, dans lequel les deux conduits (120, 233 ; 620-n) limitent le flux d'air entre le premier compartiment (111 ; 611) et le second compartiment (112 ; 612).

9. Dispositif informatique selon l'une quelconque revendication précédente, comprenant en outre un matériau (219) dans les deux conduits (120 ; 233 ; 620, 620-n) qui limitent le flux d'air entre le premier compartiment (111 ; 611) et le second compartiment (112 ; 612).

10. Dispositif informatique selon l'une quelconque revendication précédente, dans lequel des surfaces externes opposées du boîtier (101 ; 601) comportent chacune des surfaces externes respectives du premier compartiment (111 ; 611), du second compartiment (112 ; 612) et des deux conduits (120 ; 233 ; 620, 620-n).

11. Dispositif informatique selon l'une quelconque des revendications 2 à 6,
dans lequel les composants de refroidissement (115, 117 ; 215, 217 ; 617) du système de refroidissement de liquide comportent un ventilateur (117 ; 217 ; 617) et un échangeur de chaleur (115 ; 215 ; 615) relié au tube (125 ; 625, 625-n) du système de refroidissement de liquide
dans lequel le tube (125 ; 625, 625-n) achemine du liquide qui transporte de la chaleur des composants (113, 613) de traitement vers l'échangeur de chaleur (115 ; 215 ; 615) pour la dissiper, et
dans lequel le ventilateur (117 ; 217 ; 617) est positionné dans le second compartiment (112 ; 612) au niveau d'un côté faisant face à l'ouverture (642) du second compartiment pour aspirer l'air depuis l'ouverture (119 ; 619) à travers l'échangeur de chaleur (115 ; 215 ; 615), un côté opposé (242 ; 652) du second compartiment (112 ; 612), opposé au côté faisant face à l'ouverture (232 ; 642) du second compartiment (112 ; 612), comportant des ouvertures (247 ; 647) à travers lesquelles l'air sort du second compartiment (112 ; 612) après s'être écoulé à travers l'échangeur de chaleur (115 ; 215 ; 615).

12. Dispositif informatique selon la revendication 11, dans lequel les composants de refroidissement (615, 617) dans le second compartiment (612) comportent en outre un second échangeur de chaleur (615-2), et le système de refroidissement de liquide comporte un second tube (625-2) qui traverse les conduits (620-1, 620-2), à l'intérieur du boîtier (601), du premier compartiment (611) vers le second compartiment (612), le tube (125 ; 625, 625-n) acheminant la chaleur d'un premier processeur (613-1) des composants de traitement vers l'échangeur de chaleur (615-1) et le second tube (625-2) acheminant la chaleur d'un second processeur (613-2) des composants de traitement vers le second échangeur de chaleur (615-2).

13. Dispositif informatique selon la revendication 11, dans lequel les composants de traitement comportent des premiers composants de traitement (613-1) et des seconds composants de traitement (613-2), l'échangeur de chaleur comprenant des échangeurs de chaleur (615-1, 615-2) respectifs pour les premiers composants de traitement (613-1) et les seconds composants de traitement (613-2), le tube (625, 625-n) transportant la chaleur respective des premiers composants de traitement (613-1) et des seconds composants de traitement (613-2) vers les échangeurs de chaleur (615-1, 615-2) respectifs, ou
dans lequel les composants de traitement comportent une pluralité de composants de traitement (613-1, 613-2), l'échangeur de chaleur comprenant une pluralité d'échangeurs de chaleur (615-1, 615-2) dans une relation univoque avec la pluralité de composants de traitement, le tube (625, 625-n) transportant la chaleur respective de la pluralité de composants de traitement (613-1, 613-2) vers des échangeurs de chaleur (615-1, 615-2) respectifs de la pluralité d'échangeurs de chaleur.

14. Dispositif informatique selon la revendication 11, dans lequel les composants de traitement (113 ; 613) comportent une unité centrale de traitement, UCT, et une carte graphique, le tube (125 ; 625-n) acheminant la chaleur de l'UCT et de la carte graphique vers l'échangeur de chaleur (115 ; 215 ; 615).
